# FASCICULE DE BREVET EUROPEEN

(11) **EP 3 086 140 B1**
(45) Date de publication et mention de la délivrance du brevet: **24.01.2018**
(21) Numéro de dépôt: 16166642.5
(22) Date de dépôt: 22.04.2016
(51) Int. Cl.: G01T 1/185, G01T 3/00

(54) **DISPOSITIF DE DETECTION SPHERIQUE DE PARTICULES OU DE RAYONNEMENT**
KUGELFÖRMIGE ERKENNUNGSVORRICHTUNG VON PARTIKELN ODER STRAHLUNG
SPHERICAL DEVICE FOR DETECTING PARTICLES OR RADIATION

(30) Priorité: 24.04.2015 FR 1553683
(43) Date de publication de la demande: 26.10.2016
(73) Titulaire: Commissariat à l'Energie Atomique et aux Energies Alternatives, 75015 Paris (FR)
(72) Inventeur: GIOMATARIS, Ioannis, 78000 VERSAILLES (FR); MAGNIER, Patrick, 91400 ORSAY (FR); DERRE, Jacques, 92330 SCEAUX (FR)
(74) Mandataire: Cabinet Camus Lebkiri

(56) Documents cités:
- EP-A1- 2 492 711
- FR-A1- 3 007 848
- US-A1- 2013 015 778

## Description

### DOMAINE TECHNIQUE

La présente invention concerne un dispositif sphérique pour la détection de particules, telles que des neutrons, ou de rayonnements ionisants présentant une anode améliorée.

### ETAT DE LA TECHNIQUE

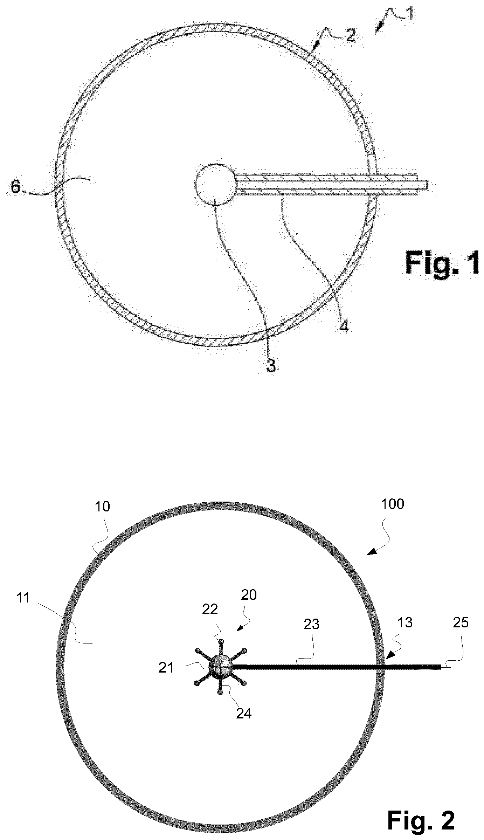

Un détecteur sphérique, tel qu'illustré à la figure 1, comporte généralement une première électrode 2 (la cathode) formant une enceinte sphérique creuse 6 remplie d'un gaz qui sert de milieu d'ionisation et de milieu d'amplification. Une deuxième électrode 3 (l'anode) en forme de bille est placée et maintenu au centre de la première électrode 2 sphérique au moyen d'une canne de maintien 4. Un tel détecteur sphérique est notamment décrit dans le document EP2492711.

Ce type de détecteur est adapté à la détection de particules non ionisantes comme les neutrons, les neutrinos, le rayonnement gamma ou des particules ionisantes comme les électrons, les positrons et les muons. Le gaz remplissant l'enceinte sphérique est ainsi choisi afin que les particules interagissent avec lui pour créer des charges qui migreront vers l'anode et qui seront amplifiées pour créer le signal à mesurer.

La première électrode sphérique 2 est reliée à la masse tandis que la deuxième électrode centrale 3 est portée à un haut potentiel positif. La détection se fait par l'ionisation des particules de gaz qui produisent alors un ion chargé positivement et un électron chargé négativement. Le champ électrique appliqué entre les électrodes permet :
- de faire dériver les électrons créés par ionisation du gaz jusqu'à la bille en créant un champ radial, et ;
- de produire une « avalanche » à proximité de la bille pour amplifier le signal.

Par exemple, dans l'art antérieur, les détecteurs sphériques présentent des volumes importants, de l'ordre de 1 m³. En effet, afin d'agrandir l'espace de détection des particules ou du rayonnement, il est nécessaire d'augmenter le rayon de l'enceinte sphérique 6. Ceci implique par conséquent d'augmenter considérablement la tension appliquée à l'anode pour créer un champ électrique suffisamment élevé pour qu'il soit apte à capter les particules ionisées loin du centre de l'enceinte sphérique 6. L'augmentation de l'espace de détection des particules nécessite également de rigidifier le support de l'anode en augmentant le diamètre de la canne de maintien 4. Comme il est nécessaire de disposer d'une anode centrale d'un diamètre plus important que celui de la canne de maintien 4 (afin de minimiser les effets « d'ombrage » de la canne de maintien), cela a pour incidence une augmentation du potentiel à appliquer sur l'anode.

Par ailleurs, pour certaines applications, il est intéressant de disposer de dispositifs de détection portables, donc avec des dimensions réduites. Avec ce type de dispositif de taille réduite, il est nécessaire d'appliquer un potentiel plus faible à l'anode de manière à éviter les phénomènes de claquage entre les deux électrodes qui se retrouvent plus proche l'une de l'autre. En revanche, ce potentiel est généralement insuffisant pour créer un champ d'amplification satisfaisant.

### EXPOSE DE L'INVENTION

Dans ce contexte, la présente invention vise à proposer un détecteur sphérique pour la détection de particules ou de rayonnement permettant de répondre aussi bien aux besoins et aux performances des détecteurs de grandes dimensions qu'aux besoins et aux performances de détecteurs de petites dimensions. Ainsi, l'invention vise à proposer un détecteur sphérique permettant de répondre aussi bien aux besoins et aux performances d'un détecteur sphérique de 10m de diamètre qu'aux besoins et aux performances d'un détecteur sphérique de 10cm de diamètre.

A cette fin, l'invention propose un dispositif de détection, selon la revendication 1, comprenant :
- une cathode en forme de sphère creuse, remplie d'un gaz d'ionisation et d'amplification ;
- une anode placée au centre de ladite sphère creuse par l'intermédiaire d'une canne de maintien ;
ledit dispositif de détection étant caractérisé en ce que ladite anode est formée par une bille isolante et par au moins deux billes conductrices positionnées autour de ladite bille isolante et à une même distance prédéterminée de ladite bille isolante.

Le dispositif de détection selon l'invention peut également présenter une ou plusieurs des caractéristiques ci-dessous, considérées individuellement ou selon toutes les combinaisons techniquement possibles :
- lesdites au moins deux billes conductrices sont reliées à ladite bille isolante par l'intermédiaire de tiges-supports placées perpendiculairement à la surface de la ladite bille isolante ;
- lesdites tiges-supports sont creuses ;
- ladite bille isolante et/ou lesdites au moins deux billes conductrices sont creuses ;
- lesdites au moins deux billes conductrices sont réparties uniformément autour de ladite bille isolante ;
- l'anode comporte au moins huit billes conductrices ;
- l'anode comporte quatorze billes conductrices ;
- ladite canne de maintien comporte un élément isolant positionné à proximité de l'anode ;
- l'élément isolant présente la forme d'une plaque positionnée à l'extrémité de ladite canne de maintien selon une direction perpendiculaire à l'axe longitudinal de la canne de maintien ;
- ledit élément isolant présente la forme d'un cône défini par un axe et par un sommet, l'axe du cône étant porté par la canne de maintien et le sommet dudit cône étant dirigé vers l'anode ;
- ladite canne de maintien est creuse de manière à permettre la traversée de moyens de liaison électrique et/ou de moyens de lecture de signal ;
- ledit élément isolant présente une forme de cône tronqué dont le sommet virtuel formé par ledit cône définit la position du centre de ladite anode ;
- ledit élément isolant forme ladite première extrémité de ladite canne de maintien ;
- ladite canne de maintien comporte un élément résistif entourant partiellement ledit élément isolant ;
- l'élément résistif est positionné autour de l'élément isolant de manière à ne pas recouvrir les deux extrémités dudit élément isolant ;
- ledit élément isolant présente une forme conique présentant un demi-angle au niveau du sommet compris entre 1° et 45°, et avantageusement entre 1° et 10° ;
- ladite canne de maintien comporte un élément résistif entourant au moins partiellement un élément isolant positionné à proximité d'une première extrémité sur laquelle ladite anode est solidarisée, ladite canne de maintien étant traversée par des moyens de liaison électrique permettant de relier électriquement ladite anode à un premier potentiel et ledit élément résistif de ladite canne de maintien à un deuxième potentiel, ledit deuxième potentiel étant inférieur au premier potentiel appliqué à ladite anode ;
- ledit dispositif est un dispositif pour la détection de neutrons.

### BREVES DESCRIPTIONS DES FIGURES

D'autres caractéristiques et avantages de l'invention ressortiront plus clairement de la description qui en est donnée ci-dessous, à titre indicatif et nullement limitatif, en référence aux figures suivantes :
- la figure 1, déjà décrite précédemment, illustre schématiquement une vue en coupe d'un dispositif sphérique de détection selon l'état de la technique ;
- la figure 2 est une représentation schématique d'un premier mode de réalisation d'un dispositif sphérique de détection selon l'invention ;
- la figure 3 est une représentation schématique d'un deuxième mode de réalisation d'un dispositif sphérique de détection selon l'invention.

### DESCRIPTION D'AU MOINS UN MODE DE REALISATION

La figure 2 représente un dispositif de détection 100 selon un premier mode de réalisation de l'invention.

Le dispositif de détection 100 comporte une première électrode 10 formant une enceinte sphérique creuse 11. La première électrode 10 est reliée à la masse de manière à former une cathode. Les termes de première électrode ou de cathode seront utilisés indifféremment par la suite avec la même référence 10.

Le dispositif de détection 100 comporte également une deuxième électrode 20 formant l'anode. De manière identique, les termes de deuxième électrode ou d'anode seront utilisés indifféremment par la suite avec la même référence 20.

La deuxième électrode 20 formant l'anode est positionnée et maintenue au centre de la première électrode 10 au moyen d'une canne de maintien 23 traversant la paroi de l'enceinte 11.

La canne de maintien 23 est creuse, et elle est traversée par des moyens de liaisons électriques 25 permettant de mettre la deuxième électrode 20 au potentiel voulu et permettant la lecture d'un signal. La deuxième électrode 20 est ainsi mise sous tension de manière à former l'anode du dispositif de détection. Les moyens de liaisons électriques 25 permettent de contrôler le champ électrique appliqué dans l'enceinte 11 en contrôlant le potentiel de l'anode 20.

Le fonctionnement d'un tel dispositif de détection est notamment décrit dans la demande de brevet FR3007848 A1. Par conséquent, la présente demande se réfère à ce document et en intègre l'ensemble des caractéristiques décrites dans ce document.

Le dispositif de détection 100 selon l'invention présente une anode 20 dont la structure est formée par :
- une bille centrale 21 reliée à la canne de maintien 23 ;
- une pluralité de billes satellites 22, i.e. au moins deux, positionnées autour de la bille centrale 21 ;
- des moyens de liaison 24, tels que des tiges-supports, s'étendant selon une direction radiale par rapport à la surface de la bille centrale 21, permettant de positionner et de maintenir les billes satellites 22 autour de la bille centrale 21 et à une certaine distance prédéterminée de la bille centrale 21, cette distance pouvant également être nulle.

La bille centrale 21 est une bille isolante réalisé en matériau isolant, par exemple en polyétheréthercétone (ou PEEK pour PolyEtherEtherKetone en langue anglaise). Cette bille centrale isolante est creuse de manière à permettre le passage des moyens de liaison électrique 25 et comporte une pluralité d'orifices radiaux répartis sur le pourtour de la surface de la bille centrale 21 pour le passage des moyens de liaison électrique 25 raccordés à chacune des billes satellites 22 ; le nombre et la répartition des orifices radiaux correspondant au nombre et à la répartition des moyens de liaisons 24 de maintien des billes satellites 22.

Ces tiges-supports 24 sont également creuses de manière à permettre le passage des moyens de liaison électrique 25 à l'intérieur des tiges-supports 24, celles-ci formant ainsi une gaine de protection des moyens de liaisons électrique 25.

Les billes satellites 22 sont des billes conductrices réalisées par exemple en acier inoxydable sur lesquelles une tension unique HV1 est appliquée par l'intermédiaire des moyens de liaison électrique 25 qui sont raccordés électriquement aux billes conductrices 22.

Les billes satellites 22 sont uniformément réparties autour de la bille centrale de manière à avoir une répartition homogène. Le choix du nombre de billes satellites sera dépendant de la taille de la sphère et de la taille de la bille centrale 21. Le nombre de billes satellites 22 sera choisi avantageusement de manière à obtenir un champ homogène dans la sphère. Toutefois, un nombre trop important de billes satellites 22 aura pour effet d'annuler les avantages de l'invention. En effet, l'anode avec sa bille centrale 21 et un grand nombre de billes satellites 22, se comporterait comme une simple bille déformée de grande dimension.

Les tiges-supports 24 sont de longueur identique et permettent ainsi de positionner les billes satellites conductrices 22 à équidistance de la bille centrale isolante 21.

Une telle géométrie de l'anode 20 en forme de «hérisson» permet ainsi de proposer un détecteur répondant à la fois aux besoins et aux performances des détecteurs sphériques de grandes dimensions (de plusieurs mètres) et de petites dimensions (de quelques centimètres). En effet, la structure particulière de l'anode 20 lui confère une double propriété : elle se comporte à la fois comme une anode de grande dimension et comme une anode de petite dimension avec des champs électriques élevés pour la collection des charges proches de l'anode pour l'amplification.

On entend par anode de grande dimension, une anode apte à détecter les particules jusqu'au voisinage de la sphère. La taille de l'anode dépend donc de la taille de l'enceinte sphérique mais également du gaz choisi pour la détection ainsi que de la tension appliquée.

On entend par anode de petite dimension, une anode petite par rapport à la taille de la sphère pour ne pas encombrer le volume détecteur et créer des champs électriques assez forts pour provoquer l'amplification (l'intensité des champs électriques étant proportionnelle à 1/*r*² où r est le rayon de l'anode).

Ainsi l'anode 20 selon l'invention permet de collecter les signaux d'avalanche qui sont amplifiés par un préamplificateur miniature à très faible bruit électronique disposé au plus près de la bille centrale isolante 21, voire même à l'intérieur de celle-ci.

Par exemple, pour la détection de particules non ionisantes, telles que des neutrons, il est nécessaire d'avoir une pression de gaz de quelques bars dans l'enceinte 11, par exemple 5 bars, afin d'augmenter leur probabilité d'interaction avec le gaz et une tension appliquée à l'anode 20 supérieure à 7kV afin de faire migrer les électrons venant de l'enceinte sphérique 21 vers l'anode 20. Inversement, pour la détection de particules très ionisantes on peut être amené à baisser la pression à l'intérieur de l'enceinte à quelques millibars et à appliquer une tension à l'anode inférieure à 2kV. Pour cette application, il est possible d'utiliser une enceinte sphérique 11 présentant un diamètre de 1,3m avec une anode formée par une bille centrale 21 présentant un diamètre de 10mm et des billes satellites conductrices 22 présentant des diamètres de 2mm positionnées à 2mm de la surface extérieure de la bille centrale 21.

Avantageusement, l'anode 20 est formée par une bille centrale isolante 21 et par au moins huit billes satellites conductrices 22 uniformément réparties autour de la bille centrale 21.

Selon un autre mode avantageux de l'invention, l'anode 20 est formée par une bille centrale isolante 21 et par au moins quatorze billes satellites conductrices 22 uniformément réparties autour de la bille centrale 21.

A titre d'exemple, l'enceinte sphérique 11 peut être réalisée en aluminium et présenter un diamètre de l'ordre de 200mm avec une épaisseur de paroi de l'ordre de 2mm.

L'enceinte sphérique 11 présente au niveau de sa paroi une ouverture 13 permettant le passage de la canne de maintien 23. Bien entendu, il est prévu d'utiliser des moyens d'étanchéité ad-hoc au niveau de la traversée de l'enceinte sphérique 11 pour le passage de la canne de maintien 23.

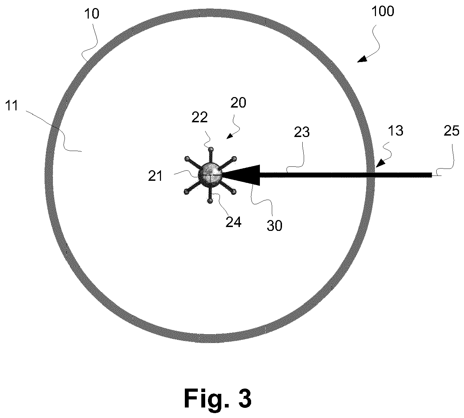

La figure 3 illustre un deuxième mode de réalisation de l'invention. L'effet de la tension appliquée sur les billes satellites 21 aura pour effet de faire migrer les électrons en surface de l'enceinte 11 vers les billes 21 mises sous tension. Toutefois, la canne de maintien 23 telle que décrite précédemment connectée à la masse du détecteur et traversant l'enceinte 11 va perturber le champ électrique au voisinage de la canne de maintien 23.

De manière à minimiser les perturbations du champ électrique liées à la présence de la canne de maintien 23, le dispositif selon l'invention comporte un élément isolant 30 positionné sur la canne de maintien 23 à proximité de l'anode 20. Cette élément isolant peut se présenter sous la forme d'une plaque positionnée perpendiculairement à l'axe longitudinal de la canne de maintien ou sous une forme conique dont la forme est définie par un axe et par un sommet, l'axe du cône étant porté par ladite canne de maintien 23 (i.e. confondu avec l'axe longitudinal de la canne de maintien 23) et le sommet dudit cône étant dirigé vers l'extrémité de ladite canne de maintien 23 (i.e. vers le centre de l'enceinte sphérique, en regard de la bille isolante 21).

Avantageusement, l'élément isolant 30 présente une forme de cône tronquée de sorte que le sommet tronqué du cône forme une surface d'appui suffisamment importante pour permettre la solidarisation de l'anode 20 à l'extrémité du cône, par exemple par collage. Le sommet virtuel du cône représente avantageusement la position du centre de la bille isolante 21 de l'anode 20.

L'élément isolant 30 est réalisé avantageusement dans un matériau plastique très isolant, par exemple du polyétheréthercétone (PEEK).

Bien entendu l'élément isolant 30 présente un orifice traversant central pour le passage des moyens de liaison électrique 25 permettant de raccorder les billes satellites 22.

L'élément isolant 30 de forme conique présente un demi-angle α au niveau du sommet compris entre 1° et 89°, avantageusement entre 1° et 45° et de manière préférentielle entre 1° et 10°.

Ainsi, la canne de maintien 23 comportant une extrémité réalisée dans un matériau isolant 30 permet de minimiser les perturbations du champ électrique dans l'enceinte sphérique 10 du dispositif de détection 100. On peut estimer qu'avec l'utilisation d'une telle canne de maintien 23, la zone perturbée est inférieure à 20% du volume total de la sphère, alors que sans l'invention environ 50% de la sphère est perturbée.

Avantageusement, la surface extérieure de l'élément isolant 30 est partiellement recouverte par un élément résistif relié électriquement à un deuxième câble électrique traversant également la canne de maintien 23. A cet effet, l'élément isolant 30 présente un orifice traversant orienté sensiblement selon une direction transverse par rapport à l'axe longitudinal de la canne de maintien 23 de manière à permettre le passage du deuxième câble électrique du centre de la canne de maintien 23 vers l'élément résistif. L'orifice transverse permet ainsi de connecter électriquement l'élément résistif à un potentiel HV2, inférieur au potentiel HV1 appliqué à l'anode 20.

L'élément résistif ne recouvre pas entièrement l'ensemble de la surface extérieure de l'élément isolant 30. En effet, l'élément résistif est agencé de manière à laisser « à nu » l'élément isolant 30 au niveau de ses deux extrémités de part et d'autre de l'élément résistif, de manière à éviter tout court-circuit entre la canne de maintien 23 raccordée à la masse et l'anode 20 au potentiel HV1.

L'application de ce deuxième potentiel au niveau de l'extrémité de la canne de maintien 23 et à proximité de la bille centrale 21 formant l'anode 20 permet de créer une décharge progressive des charges accumulées sur l'anode 20. Cette décharge progressive permet ainsi de limiter, voire de supprimer, l'apparition des claquages dus à l'accumulation de ces charges. Les charges accumulées seront ainsi éliminées par une mise à la masse via les parois métalliques extérieures de la canne de maintien 23 et par le biais de l'extrémité conique isolante. Ainsi, la zone perturbée est réduite à environ 10% du volume de la sphère.

Naturellement, l'invention n'est pas limitée aux modes de réalisation décrits en référence aux figures et des variantes pourraient être envisagées sans sortir du cadre de l'invention. Par exemple, les dimensions données dans les exemples de réalisation pour les électrodes pourraient varier, tout comme les matériaux constitutifs des électrodes et de la canne de maintien.

## Revendications

1. Dispositif (100) de détection, pour la détection de particules ou de rayonnements, comprenant :
- une cathode (10) formant une sphère creuse (11), remplie d'un gaz d'ionisation et d'amplification, et ;
- une anode (20) placée au centre de ladite sphère creuse (11) par l'intermédiaire d'une canne de maintien (23) ;
ledit dispositif de détection (100) étant **caractérisé en ce que** ladite anode (20) est formée par une bille isolante (21) et par au moins deux billes conductrices (22) positionnées autour de ladite bille isolante (21) et à une même distance prédéterminée de ladite bille isolante (21).

2. Dispositif (100) de détection selon la revendication précédente **caractérisé en ce que** lesdites au moins deux billes conductrices (22) sont reliées à ladite bille isolante (21) par l'intermédiaire de tiges-supports (24) placées perpendiculairement à la surface de la ladite bille isolante (21).

3. Dispositif (100) de détection selon la revendication précédente **caractérisé en ce que** lesdites tiges-supports sont creuses.

4. Dispositif (100) de détection selon l'une des revendications précédentes **caractérisé en ce que** ladite bille isolante (21) et/ou lesdites au moins deux billes conductrices (22) sont creuses.

5. Dispositif (100) de détection selon l'une des revendications précédentes **caractérisé en ce que** lesdites au moins deux billes conductrices (22) sont réparties uniformément autour de ladite bille isolante (21).

6. Dispositif (100) de détection selon l'une des revendications précédentes **caractérisé en ce que** l'anode (20) comporte au moins huit billes conductrices (22).

7. Dispositif (100) de détection selon l'une des revendications précédentes **caractérisé en ce que** l'anode (20) comporte quatorze billes conductrices (22).

8. Dispositif (100) de détection selon l'une des revendications précédentes **caractérisé en ce que** ladite canne de maintien (23) comporte un élément isolant (30) positionné à proximité de l'anode (20).

9. Dispositif (100) de détection selon la revendication 8 **caractérisé en ce que** ledit élément isolant (30) présente une forme de plaque positionnée selon une direction perpendiculaire à l'axe longitudinal de la canne de maintien (23).

10. Dispositif (100) de détection selon la revendication 8 **caractérisé en ce que** ledit élément isolant (30) présente une forme conique définie par un axe et un sommet, l'axe du cône étant porté par la canne de maintien (23) et le sommet dudit cône (30) étant dirigé vers l'anode (20).

11. Dispositif (100) de détection selon l'une des revendications précédentes **caractérisé en ce que** ladite canne de maintien (23) est creuse de manière à permettre la traversée de moyens de liaison électrique et/ou de moyens de lecture de signal.

## Patentansprüche

1. Detektionsvorrichtung (100) für die Detektion von Partikeln oder Strahlungen, umfassend:
- eine Kathode (10), die eine hohle Kugel (11) formt, die mit einem Ionisations- und Amplifikationsgas gefüllt ist, und;
- eine im Zentrum der genannten hohlen Kugel (11) mittels eines Haltestabes (23) platzierte Anode (20);
Wobei die genannte Detektionsvorrichtung (100) **dadurch gekennzeichnet ist, dass** die genannte Anode (20) durch eine isolierende Kugel (21) und durch wenigstens zwei leitende Kugeln (22) geformt ist, die um die genannte isolierende Kugel (21) und in einer und derselben vorbestimmten Entfernung von der genannten isolierenden Kugel (21) positioniert sind.

2. Detektionsvorrichtung (100) gemäß dem voranstehenden Anspruch, **dadurch gekennzeichnet, dass** die genannten wenigstens zwei leitenden Kugeln (22) mit der genannten isolierenden Kugel (21) mittels Trägerstiften (24) verbunden sind, die lotrecht zur Oberfläche der genannten isolierenden Kugel (21) platziert sind.

3. Detektionsvorrichtung (100) gemäß dem voranstehenden Anspruch, **dadurch gekennzeichnet, dass** die genannten Trägerstifte hohl sind.

4. Detektionsvorrichtung (100) gemäß einem der voranstehenden Ansprüche, **dadurch gekennzeichnet, dass** die genannte isolierende Kugel (21) und / oder die genannten wenigstens zwei leitenden Kugeln (22) hohl sind.

5. Detektionsvorrichtung (100) gemäß einem der voranstehenden Ansprüche, **dadurch gekennzeichnet, dass** die genannten wenigstens zwei leitenden Kugeln (22) gleichmäßig um die genannte isolierende Kugel (21) verteilt sind.

6. Detektionsvorrichtung (100) gemäß einem der voranstehenden Ansprüche, **dadurch gekennzeichnet, dass** die Anode (20) wenigstens acht leitende Kugeln (22) umfasst.

7. Detektionsvorrichtung (100) gemäß einem der voranstehenden Ansprüche, **dadurch gekennzeichnet, dass** die Anode (20) vierzehn leitende Kugeln (22) umfasst.

8. Detektionsvorrichtung (100) gemäß einem der voranstehenden Ansprüche, **dadurch gekennzeichnet, dass** die genannte Haltestange (23) ein isolierendes Element (20) umfasst, das in der Nähe der Anode (20) positioniert ist.

9. Detektionsvorrichtung (100) gemäß Anspruch 8, **dadurch gekennzeichnet, dass** das genannte isolierende Element (30) eine Plattenform aufweist, die gemäß einer zur Längsachse der Haltestange (23) lotrechten Richtung positioniert ist.

10. Detektionsvorrichtung (100) gemäß Anspruch 8, **dadurch gekennzeichnet, dass** das genannte isolierende Element (30) eine konische Form aufweist, die durch eine Achse und eine Spitze definiert ist, wobei die Achse des Kegels von der Haltestange (23) getragen ist und die Spitze des genannten Kegels (30) zur Anode (20) gerichtet ist.

11. Detektionsvorrichtung (100) gemäß einem der voranstehenden Ansprüche, **dadurch gekennzeichnet, dass** die genannte Haltestange (23) derart hohl ist, dass das Durchtreten von elektrischen Verbindungsmitteln und / oder Signallesemitteln ermöglicht wird.

## Claims

1. A detection device (100), for detecting particles or radiations, comprising:
- a cathode (10) forming a hollow sphere (11), filled with an ionizing and amplifying gas, and;
- an anode (20) placed in the center of said hollow sphere (11) by a retaining stick (23);
said detection device (100) being **characterized in that** said anode (20) is formed by an insulating bead (21) and by at least two conducting beads (22) positioned around said insulating bead (21) and at a same predetermined distance from said insulating bead (21).

2. The detection device (100) according to the previous claim, **characterized in that** said at least two conducting beads (22) are interconnected to said insulating bead (21) through support rods (24) placed perpendicular to the surface of said insulating bead (21).

3. The detection device (100) according to the previous claim, **characterized in that** said support rods are hollow.

4. The detection device (100) according to one of the previous claims, **characterized in that** said insulating bead (21) and/or said at least two conducting beads (22) are hollow.

5. The detection device (100) according to one of the previous claims, **characterized in that** said at least two conducting beads (22) are evenly distributed around said insulating bead (21).

6. The detection device (100) according to one of the previous claims, **characterized in that** the anode (20) includes at least eight conducting beads (22).

7. The detection device (100) according to one of the previous claims, **characterized in that** the anode (20) includes fourteen conducting beads (22).

8. The detection device (100) according to one of the previous claims, **characterized in that** said retaining stick (23) includes an insulating element (30) positioned proximate to the anode (20).

9. The detection device (100) according to claim 8, **characterized in that** said insulating element (30) has a plate shape positioned along a direction perpendicular to the longitudinal axis of the retaining stick (23).

10. The detection device (100) according to claim 8, **characterized in that** said insulating element (30) has a conical shape defined by an axis and an apex, the axis of the cone being along the retaining stick (23) and the apex of said cone (30) being directed toward the anode (20).

11. The detection device (100) according to one of the previous claims, **characterized in that** said retaining stick (23) is hollow so as to enable electrical connecting means and/or signal reading means to pass therethrough.
